(19) Europäisches Patentamt / European Patent Office / Office européen des brevets

(11) **EP 1 039 330 B1**

(12) **EUROPEAN PATENT SPECIFICATION**

(45) Date of publication and mention
of the grant of the patent:
**28.05.2008 Bulletin 2008/22**

(51) Int Cl.:
*G02F 1/095* (2006.01)   *G02F 1/025* (2006.01)

(21) Application number: **00302255.5**

(22) Date of filing: **20.03.2000**

(54) **Optical waveguide isolator**

Optischer Isolator für Wellenleiter

Isolateur optique pour guide d' onde

(84) Designated Contracting States:
**DE FR GB**

(30) Priority: **19.03.1999 JP 7574699**

(43) Date of publication of application:
**27.09.2000 Bulletin 2000/39**

(73) Proprietor: **The University of Tokyo
Bunkyo-Ku,
Tokyo (JP)**

(72) Inventors:
• **Nakano, Yoshiaki
Tokyo (JP)**
• **Takenaka, Mitsuru
Tokyo (JP)**

(74) Representative: **Gibbs, Christopher Stephen et al
Haseltine Lake
Lincoln House
300 High Holborn
London WC1V 7JH (GB)**

(56) References cited:
• **HAMMER J M ET AL: "POLYCRYSTALLINE-METAL-FERROMAGNETIC OPTICAL WAVEGUIDE ISOLATOR (POWI) FOR MONOLITHIC-INTEGRATION WITH DIODE-LASER DEVICES" IEEE PHOTONICS TECHNOLOGY LETTERS,US,IEEE INC. NEW YORK, vol. 9, no. 5, 1 May 1997 (1997-05-01), pages 631-633, XP000677344 ISSN: 1041-1135**
• **TAKENAKA MITSURU ET AL: "Proposal of a novel semiconductor optical waveguide isolator" PROCEEDINGS OF THE 1999 11TH INTERNATIONAL CONFERENCE ON INDIUM PHOSPHIDE AND RELATED MATERIALS (IPRM); DAVOS, SWITZ MAY 16-MAY 20 1999, 1999, pages 289-292, XP000974917 Conf Proc Int Conf Indium Phosphide and Relat Mater;Conference Proceedings - International Conference on Indium Phosphide and Related Materials 1999 IEEE, Piscataway, NJ, USA**

**Description**

The present invention relates to an optical isolator, especially an optical waveguide capable of being integrated on a substrate together with a semiconductor laser and an optical waveguide.

In optical communication systems, an optical isolator is used to prevent reflected light and scattered light in the end face of the optical fiber from returning to a light source side. An optical isolator using a rotation of the polarization plane according to the magneto-optic material has been put to practical use as an optical isolator. For example, the optical isolator of the Faraday rotation type is constituted by a polarizer, a Faraday rotator of optically transparent material and an analyzer, so that polarized components corresponding to the plane of polarization of the polarizer out of advanced circular polarization of light to the forward direction pass through the polarizer, the plane of polarization is rotated by the Faraday rotator by 45°, and they emanate by passing the analyzer which is inclined at the polarizer by 45°. On the other hand, the return light propagated in the direction opposite to the forward direction is obstructed by the polarizer, since after passing the analyzer, the plane of polarization of the return light receives another rotation of 45° by the Faraday rotator and returns to the polarizer. The polarized beam splitter and the double refraction prism are utilized as polarizer and analyzer in conventional optical waveguide isolators.

The above well known optical waveguide isolator was not able to be manufactured with a semiconductor optical element such as semiconductor lasers and optical modulators as one body, since the known optical waveguide isolator does not have the same kind of structure as a semiconductor device. Therefore, the well known optical waveguide isolator must be made as another discrete structure with the substrate of the optical circuit to which the semiconductor device such as semiconductor lasers is integrated, so that the manufacturing step becomes complicated and the manufacturing cost becomes high. Particularly, phase-matching is necessary, and precise processing is necessary, so that the manufacturing process becomes complex. On the other hand, if the optical waveguide isolator could be formed on the substrate by using the same semiconductor manufacturing technology as semiconductor devices such as semiconductor lasers and photodiodes, it could be manufactured with precise manufacturing steps and thus the manufacturing cost could be substantially reduced.

The present invention is defined in the attached independent claim to which reference should now be made. Further preferred features may be found in the sub-claims appended thereto.

Hammer J M et al: "Polycystalline-metal-ferromagnetic optical waveguide isolator ..." IEEE Photonics Technology Letters, US, IEEE Inc. New York, Vol 9 No 5, 1 May 1997 pages 631-633, XP 000 677 344 ISSN: 1041-1135 discloses that optical Faraday rotation in polycrystalline or amorphous thin films of ferromagnetic materials can be used to obtain true-optical isolators and nonreciprocal-TE-TM-mode converters which cover a wide wavelength range. These can be integrated with semiconductor lasers and other integrated optic devices because the films do not require epitaxial deposition. A detailed description and analysis of an integrable isolator with better than 30-dB isolation ratio and low insertion loss in the 1.5-$\mu$m wavelength region is given.

It is an object of the present invention to eliminate the above described disadvantages of the known waveguide isolator, and to provide an optical waveguide isolator capable of integration on the semiconductor substrate by using semiconductor manufacturing technology.

It is another object of the present invention to provide an optical waveguide isolator capable of being manufactured without requiring phase matching and without using complicated manufacturing steps.

According to the present invention, there is provided an optical isolator according to claim 1.

The present invention is based on the recognition that the refractive index, that is, the equivalent refractive index for the light wave propagating in die optical waveguide, can be changed in the entire waveguide according to the propagating direction of the light wave by using the magneto-optical or Kerr effect. If the equivalent refractive index can be changed according to the propagating direction of the light wave, the attenuation of the light wave propagated in one direction and the attenuation of the light wave propagated in the opposite direction can be made different, and thus an optical waveguide isolator can be constructed by using the difference in attenuation when the light wave propagates in the optical waveguide.

In the present invention, to obtain a nonreciprocal refractive index change by the magneto-optic effect, an optical absorptive magnetic material layer is formed on the optical waveguide and the optical absorptive magnetic material layer is magnetized in the direction corresponding to direction of vibration of the magnetic vector of the light wave propagating the optical waveguide. The light wave propagates in the optical absorptive magnetic material layer of the optical waveguide, so that the propagated light wave is subjected to the magneto-optic effect of the optical absorptive magnetic material layer as the entire waveguide structure, and thus not only the real but also the imaginary part of the refractive index becomes nonreciprocal (i.e. differs according to the direction of the light wave) in the case of the optical absorption magnetic material layer, thereby being capable of making the amount of attenuation of the light wave when propagating in the optical waveguide in accordance with the propagating direction. In this case, the amount of the attenuation can differ only by appropriately setting the magnetizable direction of the magnetic material layer according to the direction of propagation. As a result, a complicated structure for phase matching and precise processing steps become unnecessary.

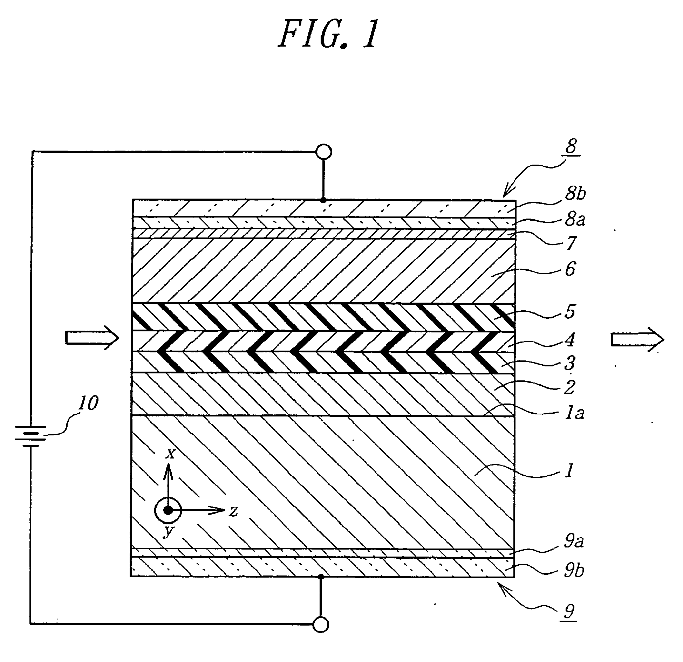

Next, the nonreciprocity of the optical waveguide structure according to embodiments of the present invention is explained theoretically due to the magnet-optical effect thereof. Here, an xyz coordinate system described later and shown in Fig. 1 (the propagating direction of the light wave is assumed to be the z direction and the directions orthogonal to the propagating direction of the light wave are assumed to be the x and y directions) is assumed. In general, the character of the magneto-optic material is shown by the dielectric tensor, and when magnetic material formed on the waveguide is not magnetized, the permittivity F is shown by the following expression:

$$\varepsilon = \varepsilon_0 \begin{bmatrix} \varepsilon_{xx} & 0 & 0 \\ 0 & \varepsilon_{yy} & 0 \\ 0 & 0 & \varepsilon_{zz} \end{bmatrix} \qquad (1)$$

Herein, $\varepsilon_0$ shows the permittivity in the vacuum. As is seen from the expression (1), when the optical absorption magnetic material is not magnetized, the dielectric tensor is symmetric, and thus does not bring about nonreciprocity of the light wave into which the equivalent refractive index therefore changes according to the propagating direction of the light wave.

On the other hand, when the optical absorption magnetic material is magnetized in the y direction, the permittivity $\varepsilon$ is shown by the following expression:

$$\varepsilon = \varepsilon_0 \begin{bmatrix} \varepsilon_{xx} & 0 & \varepsilon_{xz} \\ 0 & \varepsilon_{yy} & 0 \\ -\varepsilon_{xz} & 0 & \varepsilon_{zz} \end{bmatrix} \qquad (2)$$

As is seen from expression (2), when the optical absorptive magnetic material layer is magnetized, the dielectric tensor has non-diagonal component, so that the nonreciprocity, into which the effective refractive index changes by the magnet-optical effect according to the existence of the non-diagonal component according to the propagating direction of light wave, is caused.

The changed portion of the equivalent refractive index to the light wave propagated in the transverse magnetic mode in the z direction between the case of magnetizing the optical absorption magnetic material and the case of not magnetizing the material in the y direction can be shown by the following expression:

$$\Delta n + i\Delta k = -\frac{1}{k_0} \frac{\int j\varepsilon_{xz} \frac{1}{n^4} H_y \frac{dH_y}{dx} dx}{\int \frac{1}{n^2} H_y{}^2 dx} \qquad (3)$$

Herein, $\Delta n + i\Delta k$ shows the changed portion of the equivalent refractive index, $K_0$ is the wave number of light in the vacuum, n is the refractive index of each layer of the waveguide, and $H_y$ is a magnetic-field component of the transverse magnetic mode of the magnetic material formed on the waveguide.

On the other side, the changed component of the equivalent refractive index to the light wave propagated in the - z direction is the same as to residual elements, except only that the sign of the term of $\varepsilon_{xz}$ of the integration term at the right of expression (3) reverses. Therefore, the equivalent refractive index will differ between the travelling wave and the returning wave. By positively using the change in the equivalent refractive index of the nonreciprocity due to the magneto-optic effect, the energy attenuation amount according to the energy transfer caused when the light wave propagates in the said waveguide, from the optical waveguide to the optical absorptive magnetic material layer, changes according to the direction of propagation, so that an optical waveguide isolator can be achieved. In this case, the incident signal light can be output with light amplification by assuming the optical waveguide structure to be a semiconductor optical amplifier structure so as to compensate the attenuation amount of the signal light caused as the signal light propagates in the waveguide, so that the isolation function can be achieved without attenuating the signal light.

Next, the isolation ratio is explained. The isolation ratio IR can be shown by the following expressions.

$$\text{IR} = \text{output strength of backward propagating wave/output strength of forward propagating light} \qquad (4)$$

By using expression (2), the isolation ratio can be shown by difference $2\Delta k$ between the attenuation of the forward-propagating wave and the attenuation of the backward propagating wave. This is shown by expression (5)

$$I_R = \left| \exp(2 \left| \Delta k \right| k_0 L) \right|^2 \qquad (5)$$

Here, L is the length of the device. It was confirmed to be possible to obtain an isolation ratio of 40dB in a length of the device of about 2.0 mm since the optical waveguide isolator explained by the embodiment described later was simulated.

In a preferable embodiment of the optical waveguide isolator according to the present invention, the first light wave is a signal light to be transmitted along a transmission system, and the second light wave is the return light propagated in the direction opposite to the signal light. According to such a construction, the signal light to be transmitted is not so attenuated, and the return light such as reflected light and the scattered light caused in transmission path can be greatly attenuated.

In another embodiment of the optical waveguide isolator according to the present invention, the optical absorption magnetic material layer is constituted by magnetic material magnetized so as to have the magnetic-field component in the direction corresponding to the vibrating direction of a magnetic vector of the first light wave propagating on the waveguide. To obtain the nonreciprocity according to the magneto-optical effect, the direction of the external magnetic field should be made to correspond to the vibrating direction of the magnetic vector of the light wave having various modes propagating on the waveguide; for example, the magnetic material layer is formed in the case of the transverse magnetic mode light along the plane parallel to the substrate, so that the nonreciprocity according to the magnetoptical effect can be achieved by magnetizing the magnetic material layer in a direction orthogonal to the propagating direction of the light wave.

As optical absorption magnetic material which causes the magneto-optical effect, ferromagnetic materials of nickel, iron, and cobalt, etc. and various magnetic materials such as yttrium iron garnet (YIG) can be used.

According to a suitable embodiment of the optical waveguide isolator of the present invention, this substrate is a semiconductor substrate, and the core layer and first and second cladding layers are likewise constituted of semiconductor material. According to such a constitution, the optical waveguide isolator can be formed on the same semiconductor substrate with a semiconductor laser by using the usual semiconductor manufacturing technology.

In another embodiment of the optical waveguide isolator according to the present invention, there is provided an optical waveguide isolator comprising a semiconductive light amplifier structure including a semiconductor substrate of a first conductivity type having a surface of a layer to be formed, a first cladding layer of the first conductivity type formed on the substrate, an active layer formed on the first cladding layer, a second cladding layer of the second conductivity type opposite to the first conductivity type, formed on the active layer, a first electrode formed on the surface of the semi-conductor substrate opposite to the surface to be formed as a layer, and a second electrode formed on the second cladding layer; the first cladding layer, the active layer, and the second cladding layer constitute an optical waveguide, the second electrode includes a light-absorptive magnetic material layer magnetized so as to have a magnetic-field component in the direction corresponding to the vibrating direction of the magnetic vector of the light wave propagating in the waveguide, the optical waveguide and the magnetic material layer of the second electrode constitute an optical waveguide structure, and the waveguide structure body has a nonreciprocity optical characteristic such that the effective refractive index of the optical waveguide for the light wave propagated changes according to the magneto-optical effect of the light-absorptive magnetic material layer according to the direction of propagation. By the effective refractive index change in the nonreciprocity, the attenuation of the first light wave that propagates through the optical waveguide in the first direction caused when the said waveguide is illuminated decreases less than the attenuation of the second light wave propagating in the second direction, opposite to the first direction. If the optical waveguide isolator is constituted as a semiconductor optical amplifier, the incident signal light can be amplified by adjusting the output voltage in the DC bias source connected between the first electrode and the second electrode and can emanate as a signal light with the same energy level as the energy level at the incident time.

In another embodiment of the optical waveguide isolator having the light amplifier structure, one electrode of the light amplifier structure has a nickel layer and a gold layer which are magnetized in the direction corresponding to the vibrating direction of a magnetic vector of the first light wave. In this embodiment, there is the advantage that the electrode of the light amplifier can be co-used as an optical absorptive magnetic material layer.

For a better understanding of the invention embodiments of it will now be described, by way of example, with reference to the accompanying drawings, in which:

Fig. 1 is a diagrammatic sectional view showing the constitution of one embodiment of an optical isolator according to the present invention.

Fig. 1 is a diagrammatic cross-sectional view showing the constitution of an optical waveguide isolator in accordance with the present invention. This embodiment explains the optical waveguide isolator having a semiconductor optical amplifier structure for amplifying and emitting incident light. In Fig. 1, the light wave is propagated in the z direction, and the semiconductor layer structure is formed along the x direction by y-z plane layers stacked in the x-direction. A substrate 1 of InP of n type is prepared, and the semiconductor layer structure is formed on a layer forming surface 1a of the substrate.

The substrate 1 has a thickness of $100\mu$m, and the high impurity concentration is assumed to be $1\times10^{18}$ atoms/cm$^3$ for example. For example, sulphur can be used to provide n-type impurities.

A first cladding layer 2 of n-type InP is deposited on the substrate 1 of InP. The first cladding layer 2 has a thickness of 200 nm and a refractive index of 3.16, and the high impurity concentration is assumed to be $lx\,10^{17}$ atoms/cm$^3$. An undoped first guide layer 3 of InGaAsP is formed on the first cladding layer 2. The thickness of the first guide layer 3 is, for example, 120 nm, and the refractive index is 3.37.

An undoped active layer 4 of InGaAsP is formed On the first guide layer 3. The active layer 4 has a thickness of 100 nm and refractive index of 3.4132. For example, in this embodiment, the active layer of monolayer structure is used, but a multiple quantum well structure of InGaAs and InGaAsP can be used. An undoped second guide layer 5 of InGaAsP is formed on the active layer 4. The second guide layer 5 has a thickness of 120 nm and a refractive index of 3.37.

A second cladding layer 6 of p-type InP is deposited on the second guide layer 5. The second cladding layer has a thickness of 300 nm and a refractive index of 3.16, and its impurity concentration is $1\times10^{17}$ atoms/cm$^3$. A cap layer 7 of p-type InGaAs is formed on the second cladding layer 6. The cap layer 7 has a thickness of 30 nm, and its impurity concentration is $1\times10^{19}$ atoms/cm$^3$.

A first electrode 8 is formed on the cap layer 7. The first electrode 8 is formed by a nickel layer 8a 50 nm in thickness and a gold layer 8b 100 nm in thickness formed on the nickel layer 8a. The nickel layer 8a constitutes an upper electrode 8 together with the gold layer 8b, and functions as an optical absorption magnetic material layer which exhibits a magneto-optical effect for the light wave propagating waveguide. A lower electrode 9 is formed on the other side of the substrate 1 opposite to the layer-forming surface la. The lower electrode is formed by a titanium layer 9a 50 nm in thickness and a gold layer 9b 100 nm in thickness. A DC bias source 10 is connected between the upper electrode 8 and the lower electrode 9, so that the incident light wave is amplified to a level more than the original energy level thereof and emanates therefrom.

The optical waveguide isolator functions as a semiconductor optical amplifier and as a single optical waveguide structure. That is, the active layer 4 and the first and second guide layers 3 and 5 formed on both sides thereof constitute a core layer of the optical waveguide, the first cladding layer 2 constitutes a cladding layer formed on the one side of the optical waveguide, the second cladding layer 6 and cap layer 7 form a cladding layer formed on the other side of the optical waveguide, and the nickel layer 8a constitutes an optical absorption magnetic material layer, so that an optical waveguide is constituted by the core layer and the first and second cladding layer, and an optically absorptive magnetic material layer is constituted by the nickel layer 8a, thereby constituting a single optical waveguide structure. In this case, the waveguide-type optical waveguide isolator, having substantially the same structure as the semiconductor laser, can be integrated on the same semiconductor substrate.

It is necessary that the optical waveguide isolator according to the present invention has an asymmetrical structure with regard to the light wave propagating in the waveguide. In the embodiment shown in Fig. 1, it can be considered that the y direction extends to infinity. On the other hand, the optically absorptive magnetic material layer is formed only on one side of the substrate about the x direction, so that an asymmetrical structure is secured in the x direction.

The second cladding layer 6 has an important function in defining the distance between the core layer and the optical absorptive magnetic material layer of the optical waveguide. The thickness of the second cladding layer 6 defines the energy amount which begins to exude on the light absorptive magnetic material layer 8a side of the light wave propagating on the waveguide structure, that is, the amount that the evanescent light of the propagated light wave reaches the light absorptive magnetic material layer; it also defines the strength according to the magneto-optical effect of the propagated light wave to the optical absorptive magnetic material layer. Therefore, the thickness of the second cladding layer 6 is appropriately set in consideration of the wavelength of the light wave propagating on the waveguide and the usage as an optical waveguide isolator.

Next, the magnetizing direction of the optical absorptive magnetic material layer 8a is explained. The transverse magnetic mode wave propagated in the z direction of Fig. I(from left to right) is taken as the signal light. In this case, the magnetic vector of the transverse magnetic mode wave vibrates in the y direction. Therefore, the magnetic material layer 8a is formed to be extended along the y direction, and magnetized so as to turn from the interior side of space to the frontward side. By magnetizing the optical absorptive magnetic material layer in such a direction, the attenuation of the signal light propagating in the z direction is minimized, while the attenuation of the reflected wave and the scattered light propagated in the opposite direction (the -z direction) can be maximized, and thus a large isolation ratio can be obtained. The magnetizing direction of the magnetic material layer need not accurately correspond to the direction of the magnetic vector of the light wave propagating the waveguide, and thus the desired performance can be obtained by only magnetizing the magnetic material layer so as to have a magnetic component in the direction corresponding to the direction of the magnetic vector.

Moreover, the vibrating direction of the magnetic vector of the transverse electric mode wave is the x direction in Fig. 1, so that in the case of the waveguide propagating the transverse electric mode wave, the optically absorptive magnetic material layer, extending in a direction which is substantially orthogonal to the layer-forming surface 1a of the substrate 1, is formed on the side of the waveguide structure, and the magneto-optical effect of the magnetic material layer can be used by magnetizing the optically absorptive magnetic material layer in the x direction.

Next, the operation of the optical waveguide isolator, when the isolator shown in Fig. 1 is used as an optical waveguide isolator having light amplification operation, is explained. Assume that the signal light propagates in the + z direction (from the left side to the right side on the plane), and the return light to be attenuated propagates in the opposite (-z) direction. The optical waveguide isolator causes a strong attenuation operation for the return light and has a weak attenuation operation about the signal light. Therefore, the optical waveguide isolator performs optical amplification in such a manner that the attenuation level may at least become 0 dB for the incident signal light and the thus amplified light is emitted. The optical amplification rate is controlled by adjusting the voltage level of the DC bias source 10. As a result, the energy level of the return light can be greatly attenuated without decreasing the energy level of the signal light to be propagated.

The present invention is not limited to the above described embodiment, and various modifications and changes can be performed. For example, the compound semiconductor materials of the InP system is used in the above described embodiment, but, for example, GaAs-system semiconductor material and GaN-system semiconductor material can be used. When GaAs-system semiconductor material is used, GaAs is used as a material of the core and A1GaAs can be used as a material of the cladding layer. Moreover, when GaN-system semiconductor material is used, InGaN is used as a material of the core and GaN can be used as a material of the cladding layer.

**Claims**

1. An optical isolator including a semiconductor substrate (1) of a first conductivity type having a surface (1a) for a layer to be formed thereon, a first cladding layer (2) of the first conductivity type formed on the substrate, an active layer (4) formed between the first cladding layer and a second cladding layer (6) of a second conductivity type, a first electrode (9) formed on the surface of the semiconductor substrate opposite to the layer-forming surface, and a second electrode (8) formed on the opposite side of the second cladding layer to the active layer (6), the first and the second cladding layers (2, 6) and the active layer (4) forming an optical waveguide in which a light wave propagates, the isolator further including a light absorbing magnetic material layer (8a) being formed between the second cladding layer (6) and the electrode (8) and having a light absorption function for the light wave propagating through the optical waveguide, **characterised in that** the magnetic material layer (8a) is formed to be extended parallel to the substrate surface and transverse to the travelling direction of the light and is magnetized in the direction parallel to the substrate surface and transverse to the travelling direction of the light and the waveguide has a nonreciprocal optical characteristic such that the effective refractive index of the optical waveguide changes for the light wave according to the direction of propagation by virtue of the magneto-optical effect of the light-absorptive magnetic material layer (8a).

**2.** An optical isolator as claimed in claim 1, wherein a first light wave is a signal light to be transmitted along a transmission system, and a second light wave is the return light propagated in the direction opposite to the signal light.

**3.** An optical isolator as claimed in claim 2, wherein the signal light is a transverse magnetic mode wave, the magnetic-field component lying in the direction formed by the optical absorptive magnetic material layer (8a) in parallel to the layer-forming surface of the substrate and corresponding to the direction the magnetic vector of the signal light.

**4.** An optical isolator as claimed in claim 2, wherein the signal light is a transverse electric mode wave and the light absorption magnetic material layer (8a) is formed substantially orthogonal to the layer-forming surface of the substrate, and has the magnetic-field component direction corresponding to the direction of the magnetic vector of the signal light.

**5.** An optical isolator as claimed in any preceding claim, wherein the magnetic material is selected from magnetic materials of nickel, iron, cobalt or yttrium iron garnet (YIG).

**6.** An optical isolator according to any of the preceding claims, wherein the second electrode (8) includes the light absorptive magnetic material layer (8a) and the optical waveguide and the magnetic material layer of the first electrode (8) constitute an optical waveguide structure.

**7.** An optical isolator as claimed in claim 6, wherein the second electrode (8) has a nickel layer and a gold layer which are magnetized in the direction corresponding to the vibrating direction of the magnetic vector of the light wave.

**8.** An optical system comprising an isolator as claimed in any of the preceding claims, further comprising a DC bias source (10) connected between the first electrode (8) and the second electrode (9), thereby performing light amplification so as to compensate for attenuation of the first light wave.

**9.** An optical system, as claimed in claim 7, wherein the first light wave is signal light for optical amplification and the optical absorptive magnetic material layer (8a) is magnetized so as to have the magnetic-field component in the direction corresponding to the vibrating direction of the magnetic vector of the signal light.

**10.** An optical isolator as claimed in any of the preceding claims, wherein the semiconductor substrate (1) is made of InP, the first and second cladding layers (2,6) are of InP, and the active layer is made of InGaAsP.

**11.** An optical isolator as claimed in claim 10, wherein the first conductivity type is n type, and the second conductivity type is p type.

**12.** An optical isolator as claimed in any of the preceding claims further comprising a guide layer (3,5) situated between the active layer (4) and each cladding layer (2,6).

**13.** An optical isolator as claimed in any of the preceding claims further comprising a cap layer (7) between the second cladding layer (6) and the first electrode (8).

**Patentansprüche**

**1.** Optischer Isolator, enthaltend ein Halbleitersubstrat (1) eines ersten Leitfähigkeitstyps mit einer Oberfläche (1a), auf der eine Schicht gebildet werden kann, eine auf dem Substrat gebildete erste Mantelschicht (2) des ersten Leitfähigkeitstyps, eine aktive Schicht (4) zwischen der ersten Mantelschicht und einer zweiten Mantelschicht (6) eines zweiten Leitfähigkeitstyps, eine erste Elektrode (9), die auf dem Halbleitersubstrat gegenüber der Schichtbildungsoberfläche hergestellt wurde, und eine zweite Elektrode (8) auf der Seite der zweiten Mantelschicht, die der aktiven Schicht (6) gegenüberliegt, wobei die erste und zweite Mantelschicht (2, 6) und die aktive Schicht (4) einen optischen Wellenleiter bilden, in dem sich eine Lichtwelle fortpflanzt, wobei der Isolator zudem eine Schicht (8a) aus lichtabsorbierendem magnetischem Material enthält, die zwischen der zweiten Mantelschicht (6) und der Elektrode (8) liegt und eine Lichtabsorptionsfunktion für die sich durch den optischen Wellenleiter fortsetzende Lichtwelle hat, **dadurch gekennzeichnet, dass** die Schicht (8a) aus magnetischem Material derart hergestellt wurde, dass sie parallel zur Substratoberfläche und quer zur Wanderungsrichtung des Lichtes verläuft und in paralleler Richtung zur Substratoberfläche sowie quer zur Wanderungsrichtung des Lichtes magnetisiert ist, und **dadurch**, dass der Wellenleiter ein nichtreziprokes optisches Merkmal aufweist, so dass der effektive Brechungsindex des optischen Wellenleiters sich aufgrund des magnetooptischen Effektes der Schicht (8a) aus lichtabsorbierendem magnetischem Material für die Lichtwelle je nach der Fortpflanzungsrichtung ändert.

2. Optischer Isolator nach Anspruch 1, wobei eine erste Lichtwelle ein Signallicht ist, das entlang eines Übertragungssystems übertragen werden soll, und eine zweite Lichtwelle das zurückkehrende Licht ist, das sich in umgekehrter Richtung zu dem Signallicht fortpflanzt.

3. Optischer Isolator nach Anspruch 2, wobei das Signallicht eine transversale magnetische Modenwelle ist, wobei die Magnetfeldkomponente in der Richtung liegt, die von der Schicht (8a) aus optisch absorbierendem magnetischem Material parallel zur Schichtbildungsoberfläche des Substrates gebildet wird und der Richtung des magnetischen Vektors des Signallichtes entspricht.

4. Optischer Isolator nach Anspruch 2, wobei das Signallicht eine transversale elektrische Modenwelle ist und die Schicht (8a) aus lichtabsorbierendem magnetischem Material im Wesentlichen orthogonal zur Schichtbildungsoberfläche des Substrates gebildet worden ist und die Richtung der Magnetfeldkomponente aufweist, die der Richtung des magnetischen Vektors des Signallichtes entspricht.

5. Optischer Isolator nach einem der vorhergehenden Ansprüche, wobei das magnetische Material aus magnetischen Materialien von Nickel, Eisen, Kobalt oder Yttrium-Eisen-Granat (YIG) ausgewählt ist.

6. Optischer Isolator nach einem der vorhergehenden Ansprüche, wobei die zweite Elektrode (8) die Schicht (8a) aus lichtabsorbierendem magnetischem Material enthält und der optische Wellenleiter und die Schicht aus magnetischem Material der ersten Elektrode (8) eine optische Wellenleiterstruktur bilden.

7. Optischer Isolator nach Anspruch 6, wobei die zweite Elektrode (8) eine Nickelschicht und eine Goldschicht aufweist, die in der Richtung magnetisiert sind, die der Schwingungsrichtung des magnetischen Vektors der Lichtwelle entspricht.

8. Optisches System, umfassend einen Isolator nach einem der vorhergehenden Ansprüche, der zudem eine Gleichstromvorspannungsquelle (10) umfasst, die zwischen der ersten Elektrode (8) und der zweiten Elektrode (9) angeschlossen ist, wodurch eine Lichtverstärkung durchgeführt und so die Abschwächung der ersten Lichtwelle kompensiert wird.

9. Optisches System nach Anspruch 7, wobei die erste Lichtwelle ein Signallicht zur optischen Verstärkung ist und die Schicht (8a) aus optisch absorbierendem magnetischem Material derart magnetisiert ist, dass sie die Magnetfeldkomponente in der Richtung aufweist, die der Schwingungsrichtung des magnetischen Vektors des Signallichtes entspricht.

10. Optischer Isolator nach einem der vorhergehenden Ansprüche, wobei das Halbleitersubstrat (1) aus InP besteht, die erste und die zweite Mantelschicht (2, 6) aus InP bestehen und die aktive Schicht aus InGaAsP besteht.

11. Optischer Isolator nach Anspruch 10, wobei der erste Leitfähigkeitstyp der n-Typ und der zweite Leitfähigkeitstyp der p-Typ ist.

12. Optischer Isolator nach einem der vorhergehenden Ansprüche, der zudem eine Führungsschicht (3, 5) zwischen der aktiven Schicht (4) und den jeweiligen Mantelschichten (2, 6) umfasst.

13. Optischer Isolator nach einem der vorhergehenden Ansprüche, der zudem eine Schutzschicht (7) zwischen der zweiten Mantelschicht (6) und der ersten Elektrode (8) umfasst.

**Revendications**

1. Isolateur optique comprenant un substrat semi-conducteur (1) d'un premier type de conductivité ayant une surface (1a) pour y former une couche, une première couche de placage (2) du premier type de conductivité formée sur le substrat, une couche active (4) formée entre la première couche de placage et une seconde couche de placage (6) d'un second type de conductivité, une première électrode (9) formée sur la surface du substrat semi-conducteur opposée à la surface formatrice de couche, et une seconde électrode (8) formée sur la face de la seconde couche de placage opposée à la couche active (6), la première et la seconde couches de placage (2, 6) et la couche active (4) formant un guide d'onde optique dans lequel une onde lumineuse se propage, l'isolateur comprenant par ailleurs une couche de matériau magnétique (8a) absorbant la lumière qui est formée entre la seconde couche de placage (6) et l'électrode (8) et ayant une fonction d'absorption de la lumière pour l'onde lumineuse se propageant à travers le guide d'onde optique, **caractérisé en ce que** la couche de matériau magnétique (8a) est formée de manière à s'étendre parallèlement à la surface du substrat et transversalement à la direction de déplacement de la lumière et est magnétisée dans la direction parallèle à la surface du substrat et transversale à la direction de déplacement de la lumière, et le guide d'onde a une caractéristique optique non réciproque telle que l'indice de réfraction efficace du guide d'onde optique varie pour l'onde lumineuse en fonction de la direction de propagation en raison de l'effet magnéto-optique de la couche de matériau magnétique (8a) absorbant la lumière.

2. Isolateur optique selon la revendication 1, dans lequel une première onde lumineuse est un signal lumineux qui doit être transmis le long d'un système de transmission et une seconde onde lumineuse est le signal lumineux de retour propagé dans le sens opposé au signal lumineux.

3. Isolateur optique selon la revendication 2, dans lequel le signal lumineux est une onde en mode magnétique transversal, la composante du champ magnétique se trouvant dans la direction formée par la couche de matériau magnétique (8a) absorbant la lumière en parallèle avec la surface formatrice de couche du substrat et correspondant à la direction du vecteur magnétique du signal lumineux.

4. Isolateur optique selon la revendication 2, dans lequel le signal lumineux est une onde en mode électrique transversal et la couche de matériau magnétique (8a) absorbant la lumière est formée de manière sensiblement orthogonale à la surface formatrice de couche du substrat, et a la direction de la composante de champ magnétique qui correspond à la direction du vecteur magnétique du signal lumineux.

5. Isolateur optique selon l'une quelconque des revendications précédentes, dans lequel le matériau magnétique est choisi parmi des matériaux magnétiques, tels que le nickel, le fer, le cobalt ou la ferrite de grenat d'yttrium (YIG).

6. Isolateur optique selon l'une quelconque des revendications précédentes, dans lequel la seconde électrode (8) comprend la couche de matériau magnétique (8a) absorbant la lumière et le guide d'onde optique et la couche de matériau magnétique de la première électrode (8) constituent une structure de guide d'onde optique.

7. Isolateur optique selon la revendication 6, dans lequel la seconde électrode (8) a une couche de nickel et une couche d'or qui sont magnétisées dans la direction correspondant à la direction de vibration du vecteur magnétique de l'onde lumineuse.

8. Système optique comprenant un isolateur selon l'une quelconque des revendications précédentes, comprenant par ailleurs une source de polarisation CC (10) connectée entre la première électrode (8) et la seconde électrode (9), assurant de la sorte une amplification de la lumière de manière à compenser l'atténuation de la première onde lumineuse.

9. Système optique selon la revendication 7, dans lequel la première onde lumineuse est un signal lumineux pour amplification optique et la couche de matériau magnétique (8a) absorbant la lumière est magnétisée de manière à avoir la composante de champ magnétique dans la direction correspondant à la direction de vibration du vecteur magnétique du signal lumineux.

10. Isolateur optique selon l'une quelconque des revendications précédentes, dans lequel le substrat semi-conducteur (1) est formé d'InP, les première et seconde couches de placage (2, 6) sont formées d'InP et la couche active est formée d'InGaAsP.

11. Isolateur optique selon la revendication 10, dans lequel le premier type de conductivité est le type n et le second type de conductivité est le type p.

12. Isolateur optique selon l'une quelconque des revendications précédentes, comprenant par ailleurs une couche guide (3, 5) située entre la couche active (4) et chaque couche de placage (2, 6).

13. Isolateur optique selon l'une quelconque des revendications précédentes, comprenant par ailleurs une couche de couverture (7) entre la seconde couche de placage (6) et la première électrode (8).

# FIG. 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **HAMMER J M et al.** Polycystalline-metal-ferromagnetic optical waveguide isolator ... *IEEE Photonics Technology Letters,* 01 May 1997, vol. 9 (5), 631-633